Europäisches Patentamt

European Patent Office

Office européen des brevets

(19)

(11) Publication number: **0 234 591**
**A2**

## (12) EUROPEAN PATENT APPLICATION

(21) Application number: **87102807.2**

(51) Int. Cl.⁴: **G03F 9/00**

(22) Date of filing: **27.02.87**

(30) Priority: **28.02.86 JP 41971/86**
**28.02.86 JP 41972/86**
**06.03.86 JP 47283/86**
**07.03.86 JP 31822/86 U**
**07.03.86 JP 31823/86 U**
**16.04.86 JP 86024/86**
**23.04.86 JP 92347/86**

(43) Date of publication of application:
**02.09.87 Bulletin 87/36**

(84) Designated Contracting States:
**DE FR GB**

(71) Applicant: **Dainippon Screen Mfg. Co., Ltd.**
**1-1, Tenjinkitamachi Teranouchi-agaru**
**4-chome Horikawa-dori**
**Kamikyo-ku Kyoto-shi Kyoto-fu(JP)**

(72) Inventor: **Nishida, Fumihiko Dainippon Screen**
**Mfg., Co., Ltd**
**Patent D. 4-1-1 Tenjinkitamachi**
**Teranouchi-agaru**
**Horikawa-dori Kamikyo-ku Kyoto(JP)**
Inventor: **Taniuchi, Osami Dainippon Screen**
**Mfg., Co., Ltd**
**Patent D. 4-1-1 Tenjinkitamachi**
**Teranouchi-agaru**
**Horikawa-dori Kamikyo-ku Kyoto(JP)**
Inventor: **Yonetani, Hideaki Dainippon Screen**
**Mfg., Co., Ltd**
**Patent D. 4-1-1 Tenjinkitamachi**
**Teranouchi-agaru**
**Horikawa-dori Kamikyo-ku Kyoto(JP)**
Inventor: **Kawada, Toru Dainippon Screen**
**Mfg., Co., Ltd**
**Patent D. 4-1-1 Tenjinkitamachi**
**Teranouchi-agaru**
**Horikawa-dori Kamikyo-ku Kyoto(JP)**
Inventor: **Yazaki, Tatsuo Dainippon Screen**
**Mfg., Co., Ltd**
**Patent D. 4-1-1 Tenjinkitamachi**
**Teranouchi-agaru**
**Horikawa-dori Kamikyo-ku Kyoto(JP)**

(74) Representative: **WILHELMS, KILIAN &**
**PARTNER Patentanwälte**
**Eduard-Schmid-Strasse 2**
**D-8000 München 90(DE)**

(54) **An apparatus for composing a plurality of original films on a base sheet.**

(57) An apparatus of composing original films having register marks on desired positions of a base sheet by positioning and adheres them on the base sheet comprises a main frame, a positioning and composing table provided on the main frame, the base sheet being placed thereon, film cassettes, a position detecting stage on which one of original films is set at measuring positions of register marks of the original films, an original film carrier for transporting the original film from the film cassette onto the stage, a working head which transports the original film from the positioning and composing table to adhere the original film to the base sheet, photoelectrical sensors for detecting register marks of the original film and measuring positions of the film, a sliding frame moving on the main frame in one direction, and a saddle slidable in crossing direction with the sliding frame to support the original film carrier and the working head.

## AN APPARATUS FOR COMPOSING A PLURALITY OF ORIGINAL FILMS ON A BASE SHEET

The present invention relates to an apparatus for composing a plurality sets of color separations of, for example, yellow (Y), magenta (M), cyan (C), and black (BK), by adhering them on desired positions of each of transparent base sheets every separated color.

In the conventional photomechanical processes, there has been a work called as "composing" in which a plurality sets of original films color separated by color separation devices such as color scanner or the like are adhered onto each of base sheets of respective elemental colors by relatively positioning. This work is to be performed by positioning a plurality sets of original films, in general one set thereof consisting of four sheets of original films, such as Y, M, C and BK, and adhering them respectively on relatively identical positions of four base sheets for four elemental colors. Conventionally, this work has been carried out by hand work which can not be freed from low efficiency, and that it requests proficiency of high level. Regarding the art an apparatus for automatically carrying out the composing work is disclosed in United States Patent 4,599,l22. This automatic apparatus comprises in its frame an original film storing case, a transporting device for transporting original films, a registering light table, a base sheets storing case and a case for receiving composed base sheets. In addition, on the frame there are provided independently four devices, that is, the first one of them is a film picking-up device for picking up one sheet of original films from the base sheets storing case, the second one thereof is an original film moving device which provides a camera for optically detecting register marks of the picked up original film, the third device of the four devices is an original film transporting and adhering device for transporting original films having been held thereto to X, Y and $\theta$ directions, and the last device is a base sheet transporting device for transporting the base sheet. The above-described apparatus performs the composing work" according to the following processes.

Register marks are previously set at each of corresponding positions of one set of the original films. This process is performed by recording desired register marks together with picture images, for example, in color separation work by a color scanner. According to desired printing layout, each sheet of the first color (for example, yellow, hereinafter refer to "first color") among a plurality sets of color separated original films is adhered onto a base sheet by hand work, and by setting the base sheet to an adequate digitizer, positions of the register marks of the first colored original films are read out, and then, the read out position data are stored in a memory means. The first colored original films adhered onto the base sheet are removed from the base sheet, and these original films and the base sheet are stored respectively in each of their storing cases. Then, the apparatus is driven. In consequence the original film picking-up device picks up the original films in order from the original films storing case to set them on the original film transporting device at which positioning of the original film is roughly performed. Next, the original film moving device carries the original films onto the registering light table, and with the optically detecting camera positions of the register marks are read. Simultaneously with this operation the base sheet transporting device begins to carry a base sheet from the base sheets storing case to the composing table and sets it thereon. Then, the original film transporting and adhering device holds the original film on the registering light table, and according to the position data read out by the digitizer and data optically detected by the detecting camera, the original film is aligned to a desired position of the base sheet on the composing table and set therein. Thus, the original film is adhered thereon with an adhesive tape or the like. The afore-described a series of processes are repeated · same times as the number of the original films of the first color, and when all of the original films of the first color are composed on the base sheet, the base sheet is fed to the base sheet receiving case by the base sheet transporting device. With respect to original films of the second color and those of the followings thereto, the same processes are repeated. Thus, all of the composing operation are completed.

The above-described conventional automatic composing apparatus can carry out the composing processes automatically, however, there is a disadvantage as described as follows. That is, if the original films of the first color are not removed from the base sheet on which they were composed according to desired layout by hand work, and the very base sheet is used as it is in the following processes, and further, with respect to original films of the second color and those of the following the second color, if they are composed on positions of the base sheet according to data of composing positions of the first colored original films read out by the digitizer, between the original films of the first color and those of the second color there may sometime occur position errors. The reason therefor lies in that position reading of the register marks of the original films in the digitizer is carried out by aligning a cursor line of the digitizer by human eyes, so that it can not be freed from making positioning error of the order of hundreds of micron. Accordingly, in the afore-mentioned case between the original films of the first color and those of the second color and the following thereto positioning error of the order of hundreds of micron is generated, which results in registering inaccuracy.

In the above described conventional apparatus for the purpose of eliminating such inaccuracy, as described the above, once the original films read out by the digitizer are all removed from the base sheet, and original films of all the separation colors are composed on each of the base sheets by the same processes. Thus, positioning error is prevented. According to these processes, positions of all the original films of a plurality of separated colors can be aligned appropriately, however, in the first step between positions of the original films composed by hand work according to desired layout and actually positions at which the original films are adhered there occur gaps. In addition, in the processes the original films adhered on the desired positions of the base sheet after elaborate alignment are once removed, then again by applying the composing apparatus the original films are to be adhered. As described, there is only quite low working efficiency in this apparatus. Further, in the afore-mentioned apparatus, it is indispensably necessary to drive four kinds of transporting or moving devices along one axis or plural axes, so that a further complicated and large-scaled mechanism is required, and additional troublesome adjustment for keeping high accuracy is necessary.

## SUMMARY OF THE INVENTION

It is the first object of the present invention to provide an automatic composing apparatus in which positions of register marks of a plurality of original films of the first color composed on a base sheet according to desired layout are optically detected on a detecting and composing table by an optical sensor, and by composing original films of the second color and those of the following colors thereto according to the detected data, the original films of the second color and those of the following colors are automatically aligning to positions corresponding to positions of the base sheet set on the detecting and composing table to be composed.

The second object of the present invention is to provide an automatic composing apparatus having a simple and compact construction which perform the afore-described object.

The third object of the present invention is to provide an automatic composing apparatus for composing original films which is provided with an original films transporting device to transport a plurality of original films piled on a storing stage to any desired positions by holding with vacuum sucking means.

The fourth object of the present invention is to provide a sensing device for photoelectrically sensing positions of register marks of original films.

The fifth object of the present invention is to provide a film transporting device which holds and transports original films on the composing table to press them on a base sheet being set on the composing table by uniform pressure.

The sixth object of the present invention is to provide an automatic composing apparatus comprising an applying or adhering device which automatically applies tips of adhesive tape for adhering original films held by the transporting device to desired portions thereof.

These and other objects, advantages and features of the present invention will become more fully apparent as referring to following descriptions in the specification and accompanying drawings, wherein;

## BRIEF DESCRIPTION OF THE DRAWINGS

Fig. I is a general perspective view of an embodying apparatus of the present invention of which coverings thereof are removed;

Fig. 2 is an schematic side view of the embodiment of the present invention;

Fig. 3 is a plan view of the embodiment of which a sliding frame is removed;

Fig. 4 shows a plane view of an original film cassette in relation to cassette driving means;

Fig. 5 shows a side view of the driving means as shown in Fig. 4;

Fig. 6 is a front view of a transporting device for a base sheet;

Fig. 7 is a perspective view of a driving means for driving a working head and an original film carrier;

Fig. 8 is a perspective view of the working head;

Fig. 9 is a front view of the working head;

Fig. I0 is a side view of the working head;

Fig. II is a perspective view of a rotating position control device for the working head;

Fig. I2 is a perspective bottom view of the working head;

Fig. I3 shows original films equipped with register mark lines;

Fig. I4 is a sectional side view of an electronic sensor for detecting the register lines;

Fig. l5 shows a schematic diagram of a line detecting sensor;

Fig. l6 shows an embodiment of a control circuit for a detecting device in a composing head;

Fig l7 is another embodiment of the control circuit;

Fig. l8 shows a characteristic of a photoelectric transducer;

Fig. l9 shows a conventional control circuit;

Fig. 20 shows a schematic sectional view of applying an original film held on the bottom face of the composing head;

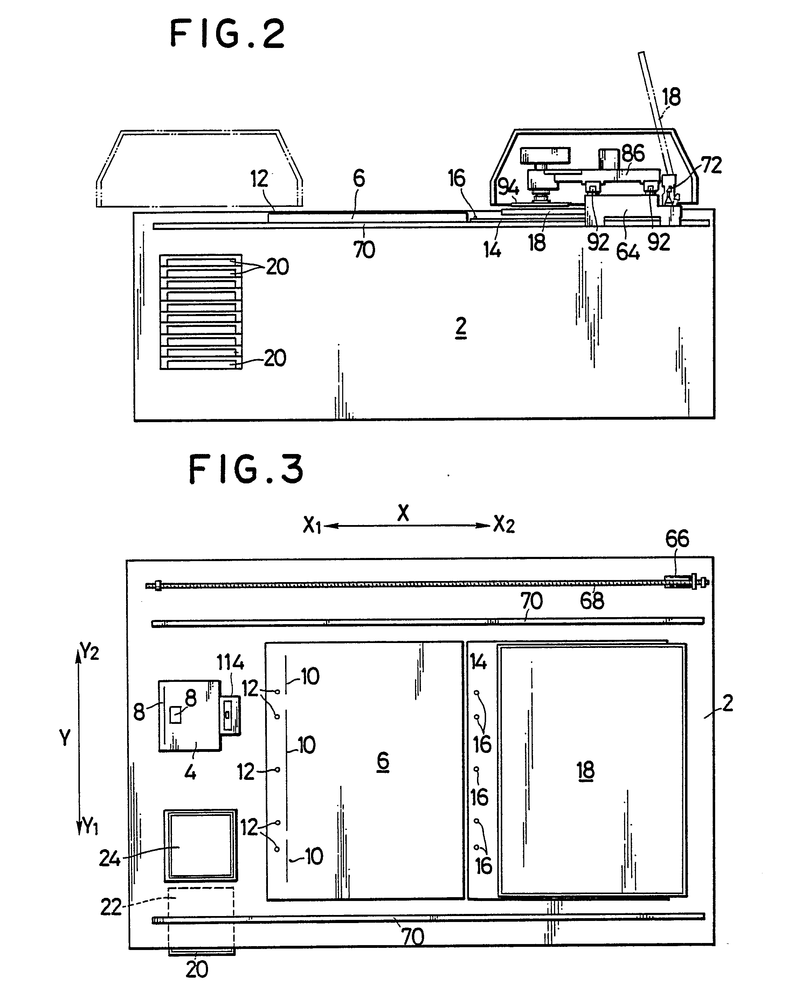

Fig. 2l is a schematic block diagram of an original film carrying system;

Figs. 22A through 22D show processes for original film carrying operation;

Fig. 23 is a perspective view of an adhesive tape application device;

Figs. 24A and 24B are front views showing function of the tape application device;

Figs. 25A through 25E show a base sheet mechanism;

Fig. 26 shows a schematic perspective view of the entire composing system a composing apparatus according to the present invention; and

Fig. 27 shows a perspective view of another embodiment of the composing apparatus according to the present invention.

## DETAILED DESCRIPTION OF PREFERRED EMBODIMENTS

The original film composing apparatus according to the present invention is adapted to perform the following operation in order, that is, color separated original films of the first color are previously composed on a base sheet according to a desired layout, coordinates values of register marks of the respective color separated original films are read out of the color separated original films by such position measuring devices as digitizer and the like, a working head which comprises register mark detecting sensors, a moving means which moves in the X and Y directions and a rotating means rotating around a vertical axis is controlled by basing on thus obtained positioning data, the register marks of each of the original films composed on the base sheet of the first color which is set on the composing table according to the desired layout are detected and stored precise position data of them, and basing on these stored data, original films of the second color and those of the following colors are composed onto respective base sheets by performing automatically positioning process.

In Figs. l, 2 and 3 there are shown a main frame 2, a position detecting stage 4 and a positioning and composing table 6. The surfaces of the position detecting stage 4 and the positioning and composing table 6 are made of an opaque material such as opal glass or grind glass, and in the insides thereof there are provided lamps for illumination. On the surface of the stage 4 a groove 8 to which a vacuum pump and an air compressor (both are not shown) are connected is cut, and same as the afore-mentioned, on the surface of the positioning and composing table 6 a groove l0 which connects to the vacuum pump (not shown) is cut. At one side of edges of the positioning and composing table 6 there are provided several register pins for positioning a perforated film(s), and these register pins project from their normal positions which sunk in the inside direction of the table when the film is set. A base sheet supplying device l4 positions a plurality of base sheets on which original films are to be composed with register pins l6, and accommodates them. A base sheet receiving device l8 for receiving base sheets on which composing work having been completed is provided on the base sheet supplying device l4, and with a pneumatic cylinder (not shown) it is raised up to a level of a two dots line shown in Fig. 2.

(Film cassette and transport device for transporting the film cassette)

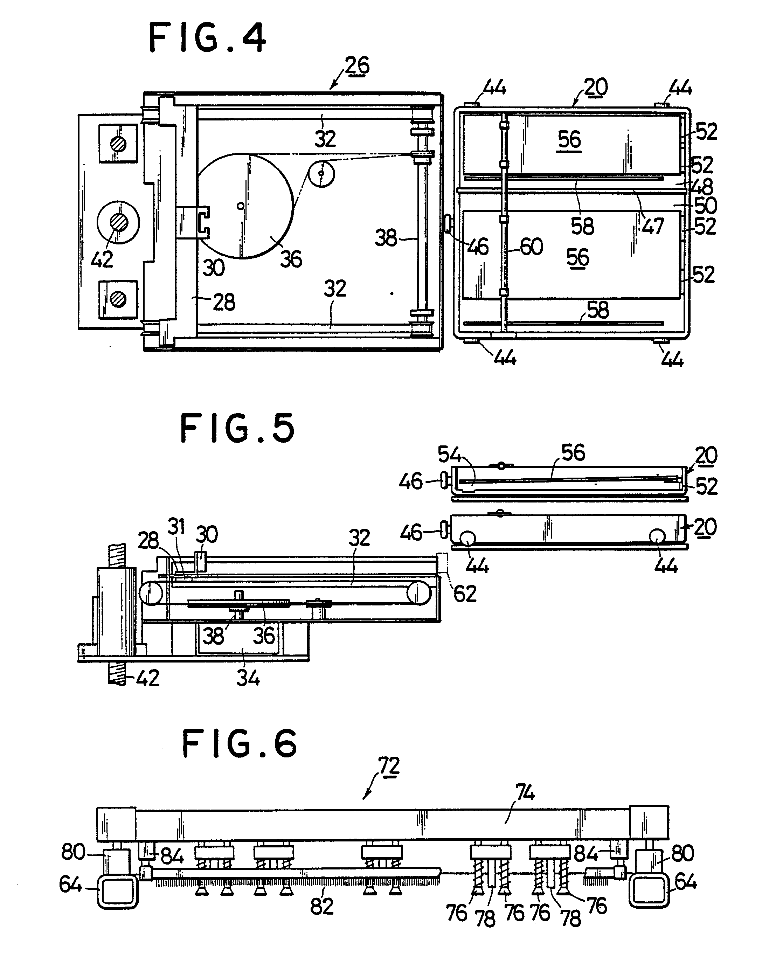

A plurality of film cassettes 20 which store original films to be adhered onto respective base sheets are transported between a waiting position 22 and a supplying position 24. Relationship between the film cassette 20 and a driving means 26 of the film cassette 20 is shown in Figs. 4 and 5, and in Fig. 5 showing a side view thereof there are two cassettes among a plurality of the cassettes are illustrated, and one of which is shown in its sectional view. In Figs. 4 and 5 a supporting bar 28 on which a hook receiver 30 is mounted is connected to a pair of driving belts 32 through a connector 3l. The driving belts 32 are simultaneously driven through a shaft 38 by a pulley 36 which is rotated with a rotary actuator 34. The cassette driving means 26 is vertically transported with a ball screw 42 driven by a motor 40 (shown in Fig. l). Each of the film cassette 20 is provided with two pairs of wheels 44 at both sides thereof, and at the rear end of it a hook 46 is also provided. The inside of the cassette 20 is divided into two sections 48 and 50 with a partition 47 to store two different sizes of films, and in the inside of each of the sections 48 and 50, a film lifting plate 56 one edge of which is hinged to wall of the cassette 20 with a hinge 52 and actuated so as to lift with a spring 54 is provided. Also a side guide 58 and a suppressing bar 60 which traverses an upper opening are provided in the inside of each of the sections 48 and 50. To move the film cassette 20 from the waiting position 22 to the supplying position 24, at first, by moving the hook receiver 30 on the supporting bar 28 by driving the rotary receiver 34 to a position 62 indicated by a chain line in Fig. 5, nextly, by driving the ball screw 42 with the motor 40, the cassette driving means 26 aligns any desired film cassette to a connecting height level. With this alignment the hook 46 of the cassette is joined with the hook receiver 30, so that when the hook receiver 30 is returned to a position indicated in a solid line by driving the rotary actuator 34, the cassette 20 is pulled toward the supplying position to the waiting position. Following thereto the motor 40 is set into re-start to lift the cassette driving means 26, and the cassette 20 is aligned to the highest level for supplying the stored original films.

(Sliding frame)

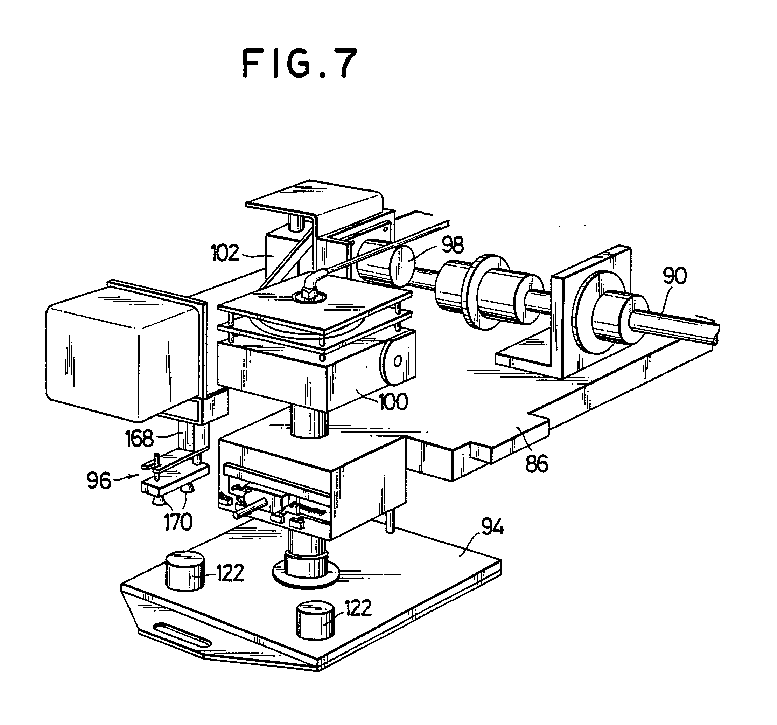

Now, returning to Fig. l, a sliding frame 64 is driven in the X -X direction shown in Fig. 3 along a pair of rails 70 on the main frame 2 by a ball screw 68 which is rotated with a motor 66. At the rear side of the sliding frame 64 a base sheet carrying means 72 is supported. The base sheet carrying means 72 is supported as follows, as shown in Fig. 6, that is, a plurality sets of suckers 76 and a plurality sets of retaining rods 78 are supported by a crossing bar 74 which travels vertically with a pneumatic cylinder 80, and further a brush 82 is supported by pneumatic cylinders 84 mounted on both ends of the crossing bar 74 so that it may be vertically moved. A saddle 86 supports a working head 94 and an original film carrier 96, and is driven with a ball screw 90 provided with a motor 88 in the Y -Y direction shown in Fig. 3 along a pair of rails 92 on the sliding frame 64. The working head 94 is rotated, as shown in Fig. 7, by rotating a hollow shaft 104 with a motor 98 through a gear box 100, and further it is vertically moved by a pneumatic cylinder 102.

(Working head)

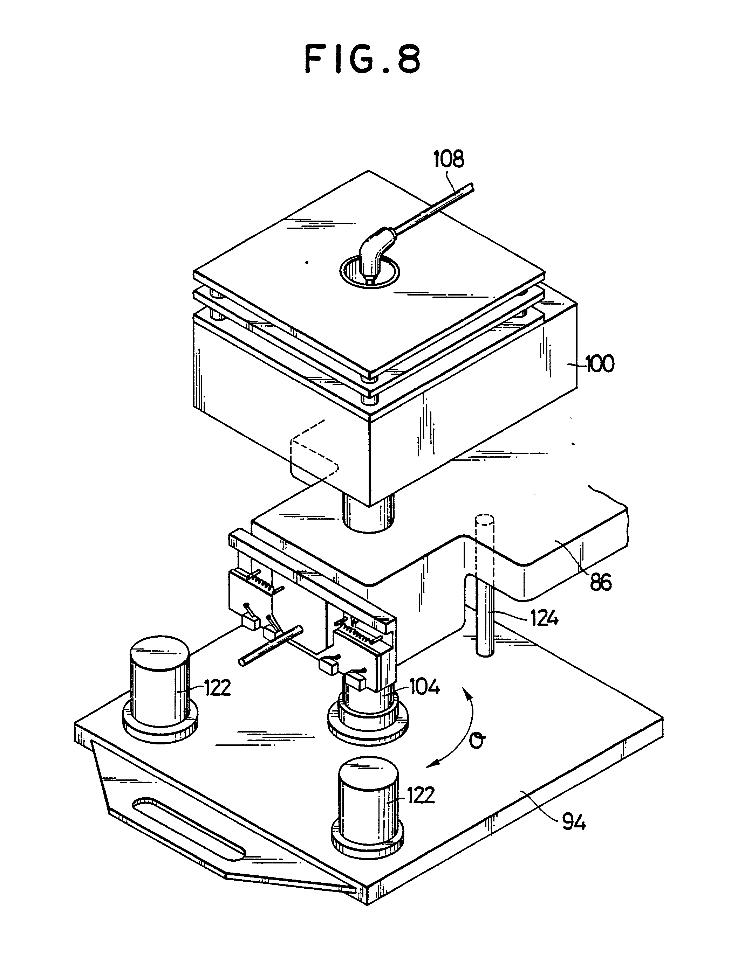

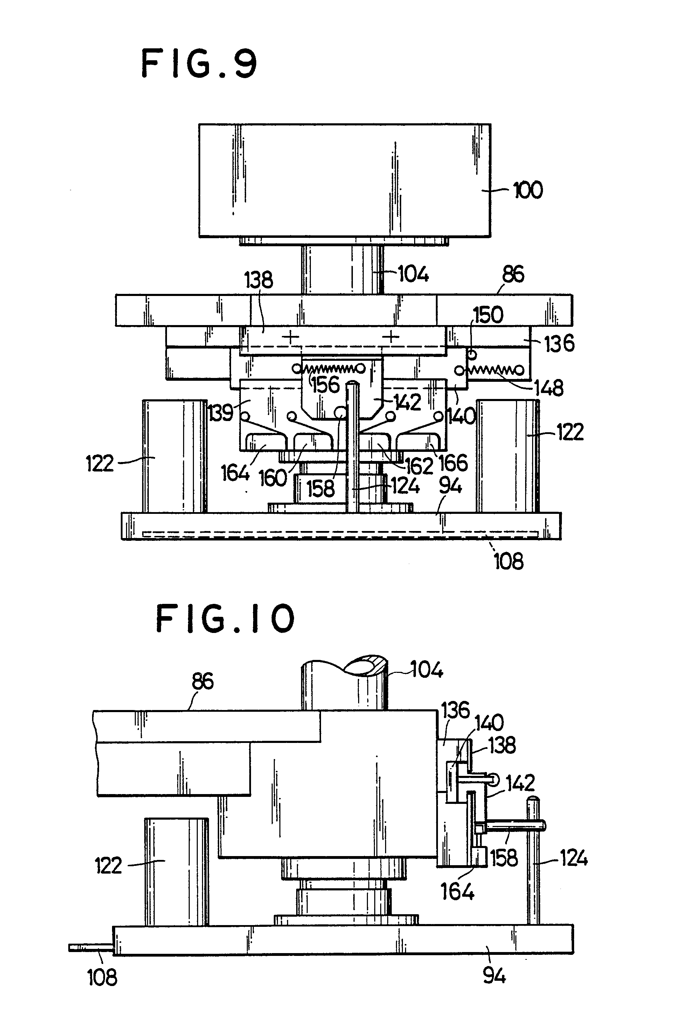

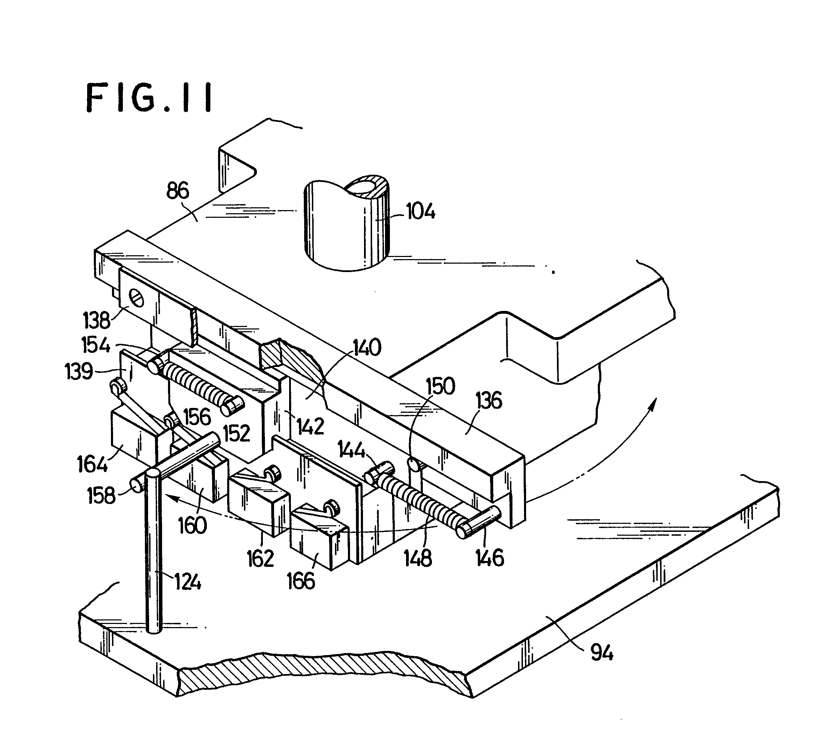

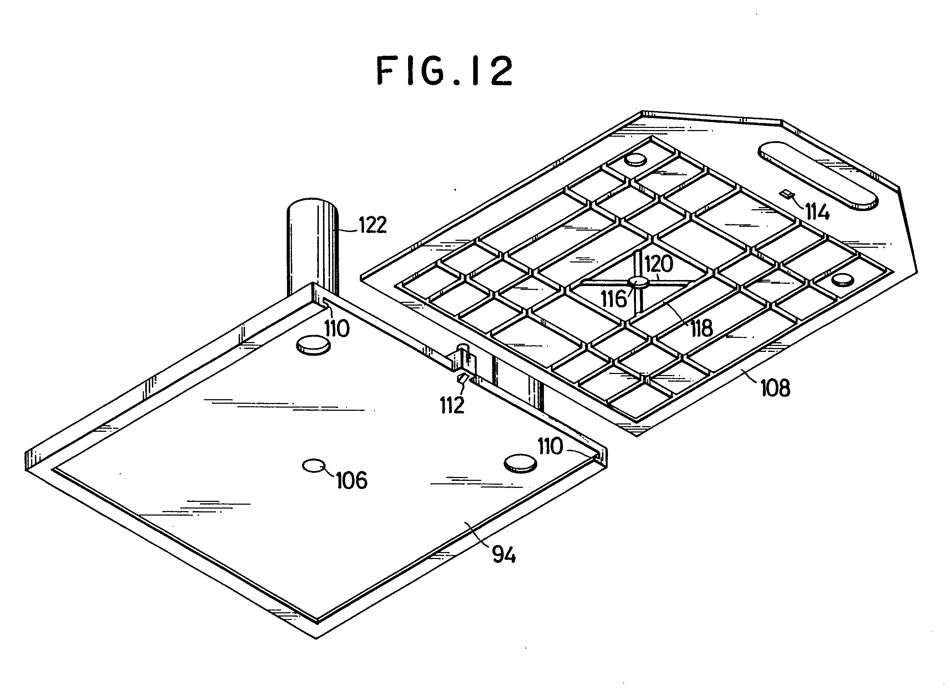

With reference to Figs. 8, 9, I0, II and I2, the working head 94 and incorporated parts and means therein will be described hereinafter.

The working head 94 is installed in the hollow shaft 104 supported with the saddle 86 so that it may be vertically moved and rotated. The lower end of the hollow shaft 104 is fitted with the central opening 106 of the lower surface of the working head 94, and the upper end thereof is connected with a pipe 108 through the gear box 100. The pipe 108 is connected to the vacuum pump and the air compressor (not shown) through a suitable control valve (refer to Fig. 2I), and in the central opening 106 performs sucking or projecting air operation. At the lower surfaces of three sides of the working head 94 there are cut grooves II0 to which a flexible board 107 is to be inserted, and a locking means 112 for holding the board 107 to a setting position is provided so as to engage with a hole 114 of the board 107. The flexible board 107 is made of a relatively thin plastic material, and at the center thereof a hole 116 which aligns to the position of the opening 106 when it is inserted into the working head 94 is bored, and at the lower surface thereof grid shaped grooves 118 for holding the original films by sucking and grooves 120 for connecting the grid shaped grooves to the hole 116 are bored. On the other hand, at the upper side of the working head 94 a pair of sensors 122 and a pole 124 are installed. The sensors 122 detect register marks of the original films and measure their positions, the pole 124 serves as a stopper for determining a reference position in the case of the working head 94 being rotated in relation with positioning switches which are described hereinafter. The sensor 122 is provided with a lens 128 and a photocell 130 in a cover 126, as shown in Fig. I4. The photocell 130 is set at a position whereby images of register mark lines are focused, when the working head 94 holds the original film(s). The photocell 130 detects positioning error of the original film(s) held by basing on the focused position of the images of the register mark lines.

Such photoelectric devices as described the above which detect positioning error of such register marks have been publicly known, one of the examples of the devices is shown in Fig. I5, in which respective pairs of same form and same characteristic photoelectric transducers 132a, 132b and 133a, 133b are arranged on center lines which cross with each other at right angle, and when an image of register mark line 134 or 135 is evenly projected to the photoelectric transducers 132a. 132b or 133a. 133b, output levels of the two transducers are equal, however, when the image of the register mark 134 or 135 is unevenly projected, output levels of the two transducers are not equal, so that in the apparatus of the present invention by utilizing the inequality of the output levels of the two transducers, whether or not the center of the register mark aligns to an optical axis of a sensor is detected.

Again referring to Figs. 8, 9, I0 and II, description of a switching device for controlling a starting point of rotation of the working head 94 will be given hereinafter. A horizontal guide rail 136 to

which an upper and a lower guide plates are attached is set at the front end of the saddle 86, and a base plate 140 and a saddle 142 are inserted into these guide plates slidably. By means of a spring means 148 which is disposed between a stud 144 projecting from the base plate 140 and a stud 146 which is the right end of the guide rail 136, the base plate 140 is energizingly actuated toward the stud 146, and thus stroke of the base plate 140 is limited by a stopper 150 set at a suitable position of the guide rail 136. The saddle 142 is actuated toward a stud 154 by a spring means 156 provided between a stud 152 projecting from the saddle 142 and the stud 154 of the left end of the base plate 140. The saddle 142 slides in the right and left directions from a common position at which it touches with the stud 154 by pushing from the common position. A contact bar 158 is projected from saddle 142 to a position where the pole 124 touches, when the working head 94 rotates. Accordingly, at an ordinary condition, the base plate 140 is held at a neutral position where it touches with the stopper 150 and the saddle 142 is held at a neutral position where the saddle 142 touches with the stud 154, and on the other hand, when the working head 94 is rotated so that the pole 124 may push the contact bar 158, the saddle 142 slides toward the direction of its being pushed.

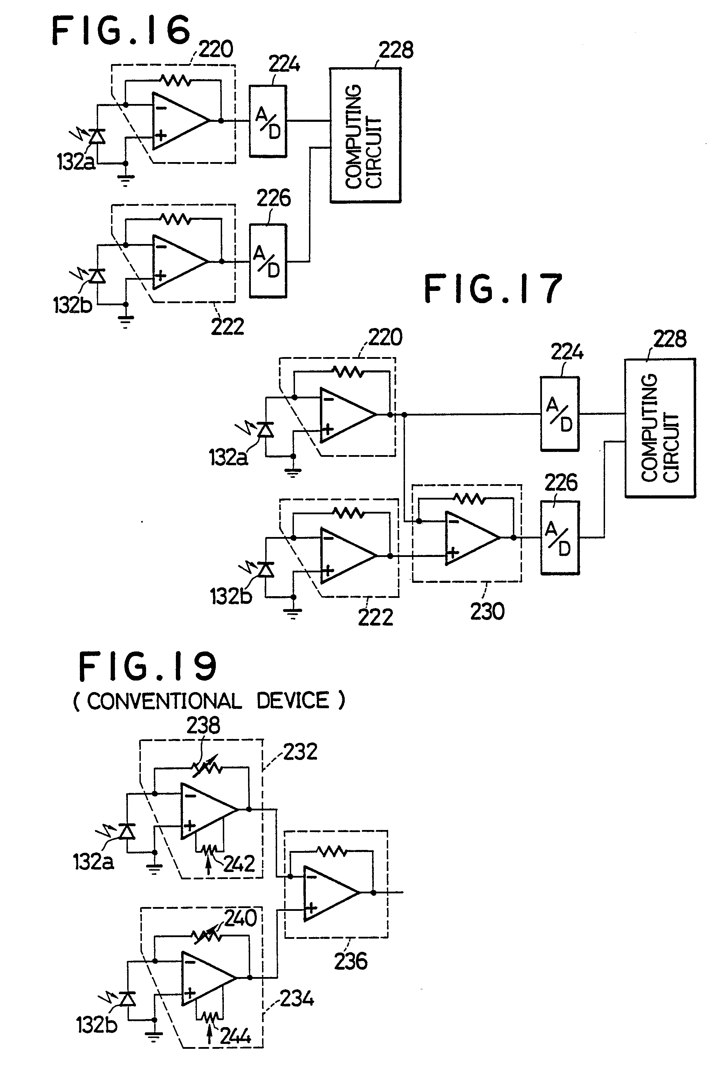

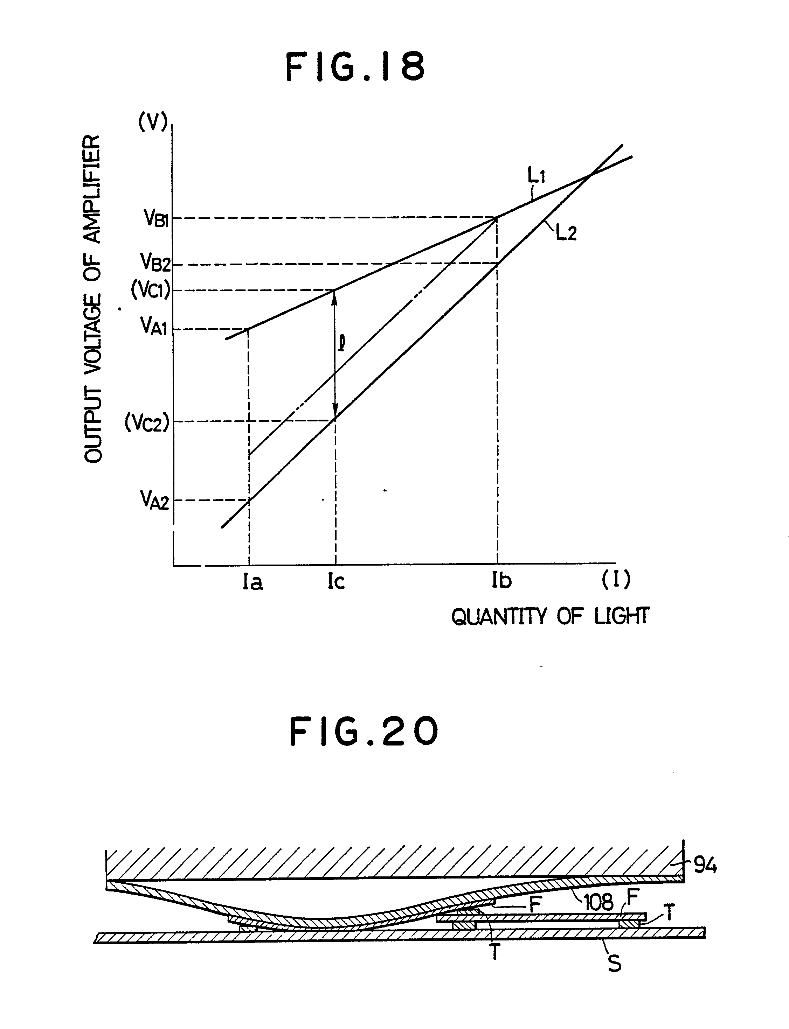

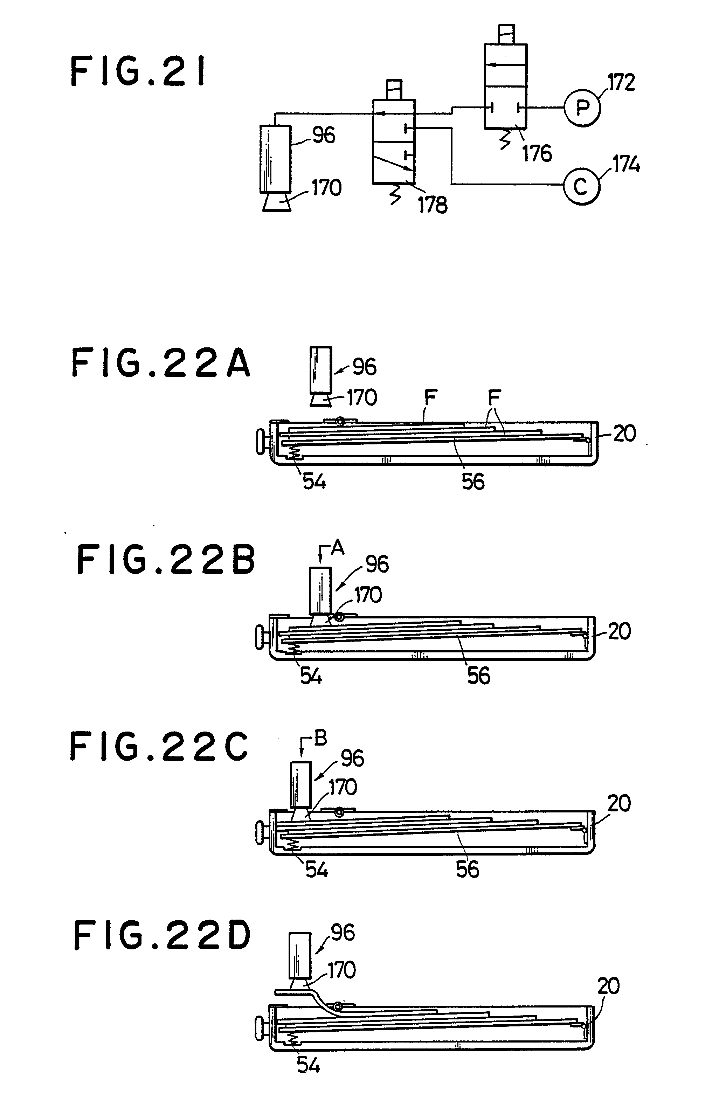

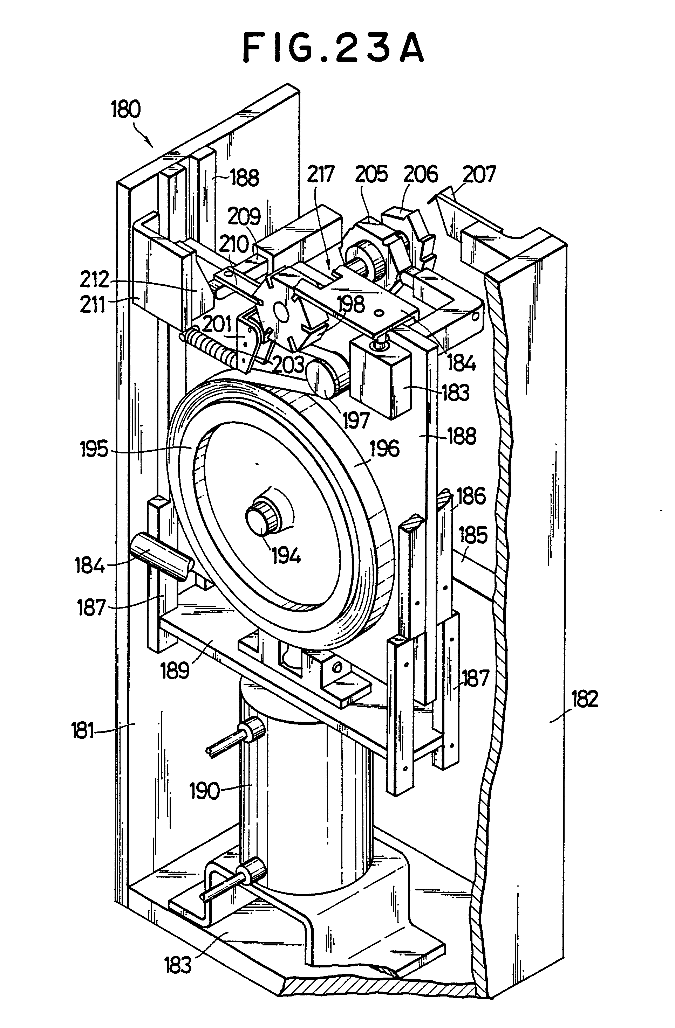

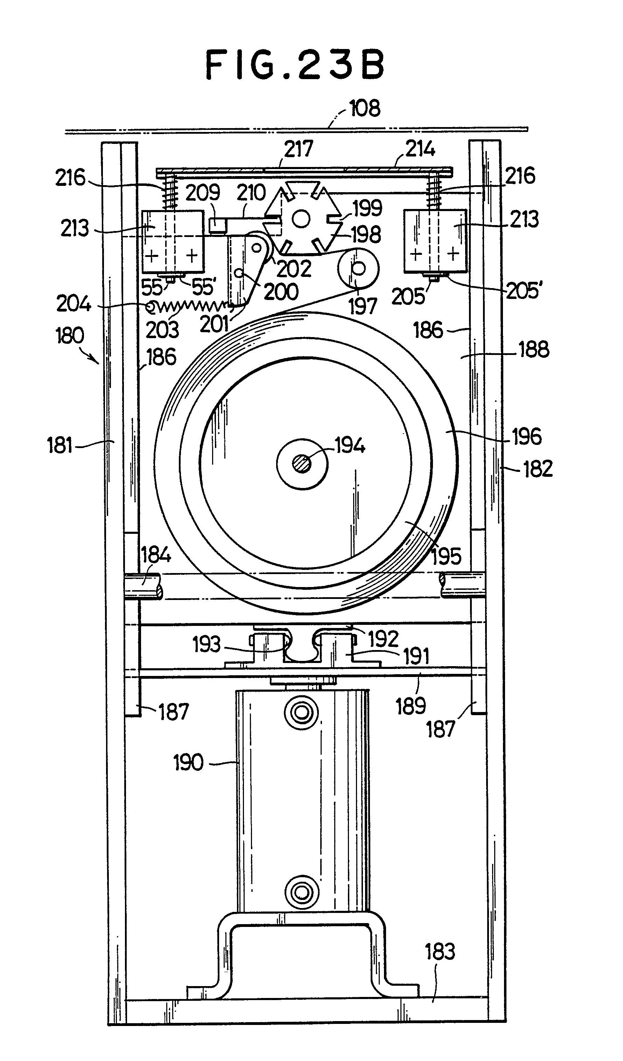

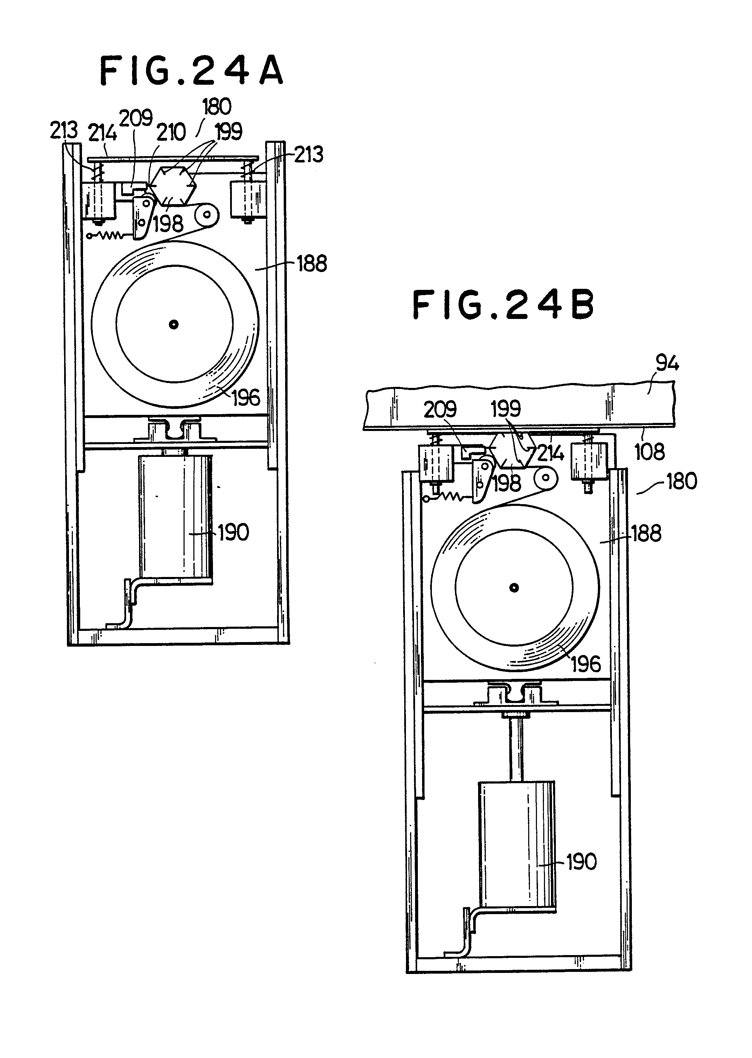

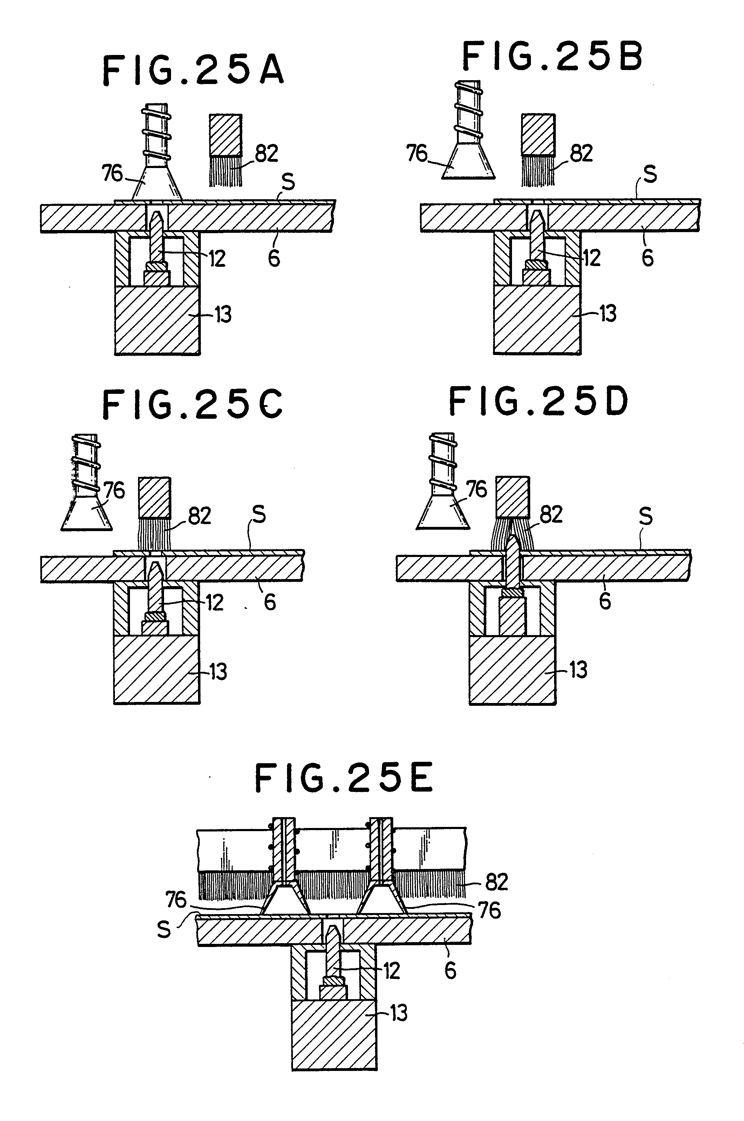

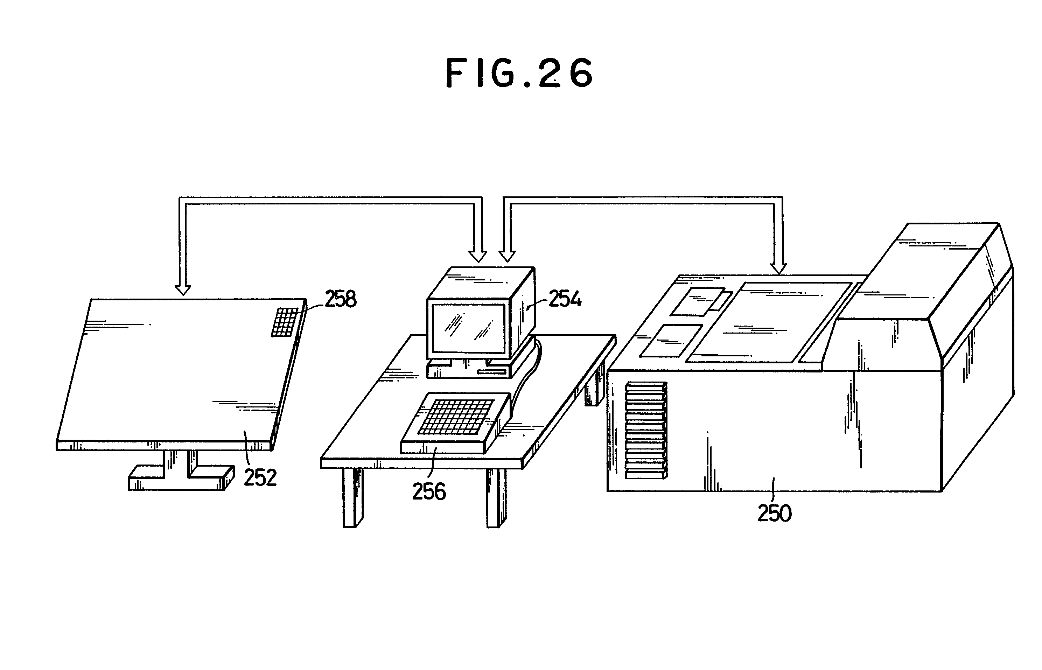

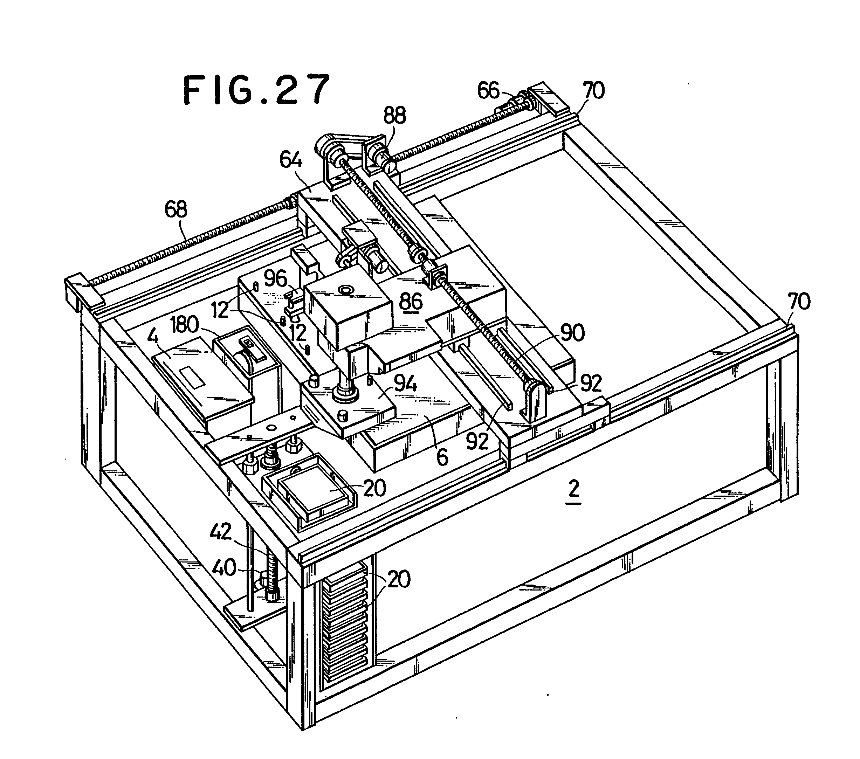

At the lower front part of the guide rail 139 there are provided four limit switches 160, 162, 164 and 166 so that each of their actuating levers may be pushed down by the bevelled lower edge thereof, when the saddle 142 shifts. Among the four switches two of them, 160 and 162 which are in the inside thereof detect limited points of the rotating stroke of the working head 94, and further they generate a starting position signal for controlling the rotation. That is, as shown in Fig. II, the starting point of the working head 94 is determined to a point where the working head 94 is rotated clockwisely, and the saddle 142 is shifted in the left direction to actuate the switch 160. In this case, that is, in determining the starting point, it is preferable to determine the starting point as such a point that at which when the actuating lever of the switch 160 is pushed-down by the saddle 142, and the switch 160 is turned to OFF state, the clockwise rotation of the working head 94 is stopped, and then the working head 94 starts counterclockwise rotation to reverse the saddle 142 so that the switch 160 may be turned to ON state. The remaining two switches 164 and 166 provided at the outside are emergency switches which stop the entire apparatus, when because of electrical or mechanical hindrance the head rotation of the working head 94 does not stop even after the saddle 142 touched with either of the inside switch 160 or 162. Figs. 16, 17 and 18 show an

electrical circuit for detecting the register mark line by the sensor 122, and Fig. 20 shows a state wherein an original film held on a base sheet is pressed by the working head 94.

With respect to particulars thereof descriptions will be given together with functions of the whole apparatus hereinafter.

(Original film carrier)

As shown in Fig. 7, an original film carrier 96 which is disposed along with the working head 94 and picks-up original films from the cassette is provided to the saddle 86. This original film carrier 96 is provided with a plurality of suckers 170 which are vertically movably supported with a pneumatic cylinder 168. These suckers 170 are selectively connected to, as shown in Fig. 21, either of a vacuum pump 172 and an air compressor 174 through electromagnetic valves 176 and 178. The sucker connected to the vacuum pump holds an original film and carries it, and the air compressor 174 smoothly removes the original film held by the sucker. Figs. 21A through 21D illustrate a process by the working head 96 for holding the uppermost sheet of the original films stored in the film cassette 20 in a manner of being piled up on the lifting plate 56 of the cassette 20. In these figures thickness of the original films (F) is exaggeratively shown. By driven the sliding frame 64 and the saddle 86 with the motors 66 and 88, the suckers 170 of the original film carrier 96 are coincided with a position of the original film cassette 20 set at the supplying position 24. With reference to Fig. 21A, the air cylinder 168 is operated to descend the original film carrier 96, and as shown in Fig. 21B, the suckers 170 and the uppermost sheet of the original films (F) are contacted with each other at a first position (A). Then, according to movement of the saddle 86, the suckers 170 are shifted to the left hand of the drawing, and because of friction generated between the suckers and the film, the uppermost sheet film is shifted in the same direction so far as the left edge of the sheet film being touched with one wall of the cassette. After the edge having touched with the wall, the suckers slip the surface of the film, and further shift to stop at a second position (B) shown in Fig. 21B. When the suckers 170 are shifted to the second position (B), the left edge of the uppermost sheet film fully contacts with the wall of the cassette 20 to be positioned appropriately. This function is carried out smoothly with the reason that the films (F) are pressed to the suckers 170 under a certain constant pressure by the spring means 54 which lifts the lifting plate 56. Next, with operation of the electromagnetic valve 176, the suckers 170 hold the original films (F) by vacuum pressure. (Fig. 22C). Sequently, with the air cylinder 168, the film carrier 96 is raised, as shown in Fig. 22D, and the original films held therein are picked-out of the film cassette 20. Then, because of movement of the saddle 86, the original film carrier 96 is transported to the left direction shown Fig. 22D, and the original film (F) having been held is carried on the position detecting stage 4.

The traveling stroke of the suckers from the first position (A) to the second position (B) may be selected according to difference between edge positions of the original films piled in the film cassette, however, it is indispensably necessary for the stroke to be selected so that the uppermost sheet of original films in the film cassette may be contacted with it, even at any cases when the suckers are descended. This selected stroke can be made some dozens millimeters or less than it in the case of controlling positions of the original films by suppressing the surface of the uppermost sheet of the piled films (F) with the suppressing bar 60 - (shown in Fig. 4). In each of Figs. 22A, 22B, 22C and 22D, by contacting the left edge (corner) of the film to be carried with the wall of the film cassette, positioning of the films is performed. However, of course, any separated part or parts for positioning may be provided therewith as an appendix or appendices. In addition, the above descriptions are concerned with one direction positioning, by driving not only the saddle 86 but the sliding frame 64, positioning in two directions are also possible. In the case of positioning in two directions, diagonal movement thereof also may be possible by driving both of them simultaneously, or driving it twice one by one directions. Each of the original films held by the carrier 96 are transported onto the position detecting stage 4, and by detecting register mark lines thereof with the photoelectric sensor 122, they are accurately aligned, and held by the working head 94. Detailed description regarding the aforementioned function will be developed hereinafter.

(Tape applicator)

The working head 94 is transported onto a tape applicator 180 which supplies tips of adhesive tape to the original films being held in it, and in accordance with controlled movements of the sliding frame 64 and the saddle 86 it aligns portions of the original films being held therein onto which tips of the adhesive tape are to be applied with the tape applicator 180 in order. Fig. 23A is a perspective view showing a construction of the tape applicator 180, Fig. 23B is a front view thereof, and Figs. 24A and 24B show functions of the tape applicator 180. A U-shaped frame is formed by a pair of side panels 181, 182, the bottom plate 183 and a pair of supporting rods 184 and 185. In the inside of each of the side panels 181 and 182 there are installed vertically a pair of guide rails, respectively. These guide rails are divided into upper rails 186 and lower rails 187, respectively, and between the upper rails 186 a vertical board 188 is vertically and slidably inserted, while between the lower rails a horizontal board 189 is also vertically and slidably inserted. The horizontal board 189 is connected to a piston rod of a pneumatic cylinder 190 installed on the bottom panel 183, and according to operation of the pneumatic cylinder 190, it is moved vertically. On the upper surface of the horizontal board 189 there is mounted a hook receiver 191, and at the lower end of the vertical board 188 a hook 192 is provided. A pair of plungers 193 which are actuated toward the inside are installed to form a click-stop mechanism which engages with the hook 192 at its neck. When the hook 192 engages with the receiver 191, both the vertical and the horizontal board 188 and 189 are driven by the pneumatic cylinder 190, while when the vertical board 188 is raised by a hand, the engagement is released and the vertical board 188 can be separated from the frame. Resetting of the vertical board 188 can be performed by inserting it between the guide guide rails 126 to engage the both boards. A wheel 195 is journally provided onto a shaft 194 projecting from the central part of the vertical board, and a loop of an adhesive tape 196 is set. As the adhesive tape 196 an adhesive tape of a type in which both faces thereof are coated with an adhesive material is used. At the upper part of the vertical board 188 a guide roller 197 is journally and rotatably provided, and at the uppermost part thereof a hexagonal rotor 198 is also rotatably journalled. The hexagonal rotor 198 has a polygonal shape (in the embodiment it is shown as a "hexagon"), and at each corner a slit 199 directing radially is provided. Circumferential surfaces of the rotor 198 are formed with suitable materials such as fluoroplastic resin so that the adhesive tape attached thereto may be easily peeled off therefrom. It is also preferable to form the guide roller 197 with the same materials. A rocking piece 201 is supported with a shaft 200 provided to the vertical board 188. On the upper part of the rocking piece 201 a roller 202 is provided, and a spring means 203 is disposed between the lower part of the rocking piece 201 and a stud 204 projecting from the vertical board 188 so that the roller 202 may be pressed to the rotor 198. A positioning cam 205 which rotates together with the rotor 198 and a ratchet wheel 206 are provided to a rotor shaft extending to the back side of the vertical board 188. The ratchet wheel 206 engages with a hook means 207 provided to the upper part of the side panel 182, when the vertical board 188 is elevated, and

rotates itself at a certain angle (for example, in the embodiment it rotates 60 degrees). The positioning cam 205 is a polyconal shape (similar to that of the rotor) and has several recesses each one to respective corners thereof for positioning purpose, and it engages with a plunger 208 provided so as to direct to the cam 205, and positions one of the surfaces of the rotor 198 upwardly. At the left half side of stepped-down upper edge of the vertical board 188a cutting arm 209 driven in the front and the rear directions is provided. The cutting arm 209 is actuated in the front direction with a suitable spring means (not shown), and further when the rotor 198 is positioned by the cam 205, the knife 210 is set so that it may be aligned with one of the slits.

At the upper part of the side panel 181 a cutter operating cam 212 with which the tip part of the cutting arm 209 engaged is provided with a bracket 211. That is, when the vertical board 188 descends, the cutting arm 209 is pushed by the cam 212 and the knife 210 is intruded into the slit 199 of the rotor 198, and when the vertical board 188 elevates, the cutting arm 209 advances along a slope of the cam 212 and pulls out of the slit 199. In addition, at the uppermost part of the front side of the vertical board 188 a pair of blocks 213 are provided. With shafts 215 slidably and vertically inserted to these blocks 213 a press pan 214 is horizontally supported avobe the rotor 198. Between the press pan 214 and each of the blocks 213 there is provided a spring 216, respectively. On the lower ends of the shafts 215 there are set stopping washers 215' to limit the stroke end of the press pan 214, and the central part of the press pan 214 an opening 217 of a size through which the rotor 198 can pass is bored. The press pan 214 is, at normal time, remote from the rotor 198, as shown in Fig. 24A. When the vertical board 188 is elevated, the press pan 214 contacts with an original film held in the lower surface of the working head 94 which is placed on the upper part of the tape applicator 180, and further according to elevation of the vertical board 188, springs 216 are compressed to hold the original film on the working head 94 by suitable pressure. Functions of the afore-described tape applicator will be described minutely in associating with the whole functions of the present apparatus hereinafter.

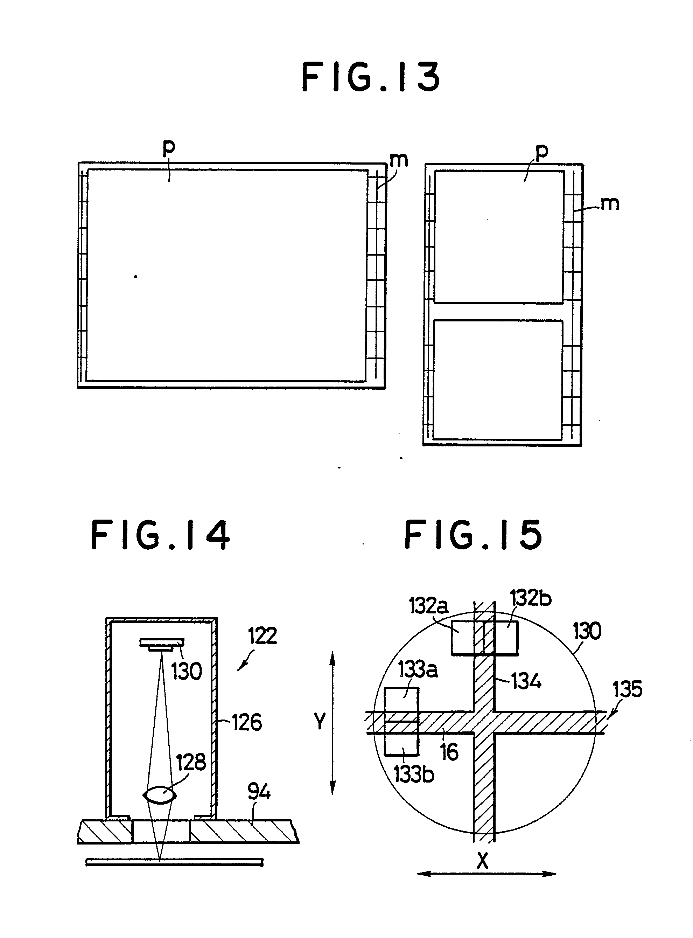

In Fig. 26 which shows an outline of the entire system for composing works, there are shown a digitizer 252 providing with a menu tablet 258, a computer 254 having a key board 256 together with an apparatus 250 of the present invention. At first, a plurality sets of color separated films of original color films to be reproduced are prepared on a base sheet of paper, and films of a first color - (for example, yellow) in each of the plural sets of original color films are composed on the base sheet by adhering with hand work according to a desired layout, then the base sheet (hereinafter termed as "first color base sheet") is set on the digitizer 252 by positioning with suitable means such as register pins or the like. On the original films composed on the first color base sheet, register marks (m) as shown in Fig. 13 are recorded together with a color separated picture (p) at their marginal edges. Positions of these registered marks (m) and sizes of the original films are measured with the digitizer, and data thereof are sent to the computer 254 to be stored therein. Reading out of the data can be performed by aligning a cursor line of the digitizer with the register marks - (m) by human eyes with the accuracy of tolerance of hundreds of micron. By raising the base sheet receiving device 18 as shown in Fig. 2 by a two dots line, and by overlapping the first color base sheet on which the original films are adhered with desired number of the following sheets, it is set on the base sheet supplying device 14 by positioning with the register pins 16. The first color base sheet must be set on the uppermost sheet among the following sheets on which no original film is adhered. While by aligning leading edges of the original films of the second color and those of the following colors in order, they are stored in the film cassette 20. By selecting widths of the separated sections 48 and 50 of the film cassette 20 so that they may coincide with those of the original films, side edges of the stored original films are also aligned. Further, in general kinds of sizes along the main scanning direction of the color separated films recorded by a color scanner are relatively small number which depends on specification of the color scanner having been used, so that film cassettes having different widths in the sections 48 and 50 may be prepared according to color scanners to be used. After setting of the base sheets and the original films has been completed, the number of cassettes in which the original films are being set, other indispensable conditions or terms are set by the menu tablet 258 of the digitizer 252 or the key board 256 of the computer 254.

(Sensor calibration)

The working head 94 travels onto an illuminating area and an outer dark area of the positioning and composing table 6, and at each of these areas sensitivities of the sensors 122 are calibrated. Detailed descriptions therefor will be given hereinafter.

Supplying base sheets is carried out as follows. The sliding frame 64 moves in the $X_2$ direction shown in Fig. 3, and the base sheet carrier 72 is aligned to the right above the register pins 16 of the base sheet supplying device 14 and stops. The

crossing bar 74 is descended to a position at which the suckers 76 contact with the piled base sheets, and then the first color base sheet is held with an appropriate vacuum pressure and elevated. The sliding frame 64 moves in the X₁ direction, the film carrier 72 alignes at the right above the register pins l2 of the positioning and composing table 6 and stops there to descend the carrier bar 74, thereby, as shown in Fig. 25A and Fig. 25E, the base sheet (S) held by the suckers 76 is put on the table 6. In this case the register pins l2 of the table 6 are sunk lower than the surface of the table. By stopping suctioning operation of vacuum pressure, and if necessary by blowing air, the base sheet (S) is released from the suckers. Next, by shifting the sliding frame 64, as shown in Fig. 25B, the brush 82 is aligned at the right above of the register pins l2, and then the brush 82 is descended by the pneumatic cylinder 84 to touch the base sheet(S), as shown in Fig. 25C. The register pins l2 are projected on the surface of the table 6 by the pneumatic cylinder l3, and inserted into corresponding pin holes of the base sheet (S). In this case, if the pins are misaligned with the corresponding pin holes, since tapered portions of the pins contact with edges of the pin holes and the base sheet (S) is pressed onto the table by the brush 82 with lower pressure so that they may be easily shifted in the horizontal direction, when the pins fully project on the surface, as shown in Fig. 25D, the pins holes of the sheet (S) are correctly engaged with the register pins l2, and thus accurate positioning can be achieved. In processes shown in Figs. 25A and 25B, the base sheet is put thereon, however, at areas of the surface of the table 6 excepting for those areas, that is, edge portions engaged with the register pins l2 the base sheet can not be sufficiently fitted thereto. In order to realize sufficient fitting with each other, the sliding frame 64 is driven in the X₂ direction under a condition at which the base sheet (S) is being contacted with the brush 82, and the surface of the base sheet (S) is rubbed by the brush 82. Then, the vacuum pump (not shown) connected to the groove l0 cut on the surface of the table 6 is operated to fix the base sheet (S) on the surface of the table 6 by suctioning operation. After then the register pins l2 are withdrawn in the inside of the table 6.

Basing on data read and stored in the digitizer 2l2, the sliding frame 64 and the saddle 86 are driven to align the sensors l22 of the working head 94 with portions of the register marks of the first color original films composed on the base sheet on the table 6 sequentially, and by projecting an image of the register mark onto the photocell l30 of the sensor, difference existing between the data read in the digitizer 2l2 and the actual position of the register mark is measured. Fig. l6 shows an embodiment of an electric circuit for the measurement in which each of output signals of the photoelectric transducers l32a and l32b (in Fig. l5) is amplified by the respective amplifiers 220 and 222, and digitized by A/D converters 224 and 226, respectively. Thus, both of the output signals are input to a computing circuit 228.

In Fig. l8 there are shown characteristic curves which represent relationships between light quantity (I) received by the transducers l32a and l32b and output voltages of the amplifiers 220 and 222 corresponding to the output signals, wherein "L₁" indicates an output characteristic of the transducer l32a, and "L₂" indicates an output characteristic of the transducer l32b. Prior to measuring positions of register marks, calibration of each of the transducers is performed. To carry out the calibration the sliding frame 64 and the saddle 86 are driven to transport the working head 94 onto the illuminated area of the positioning and composing table 6 and onto the outer dark area, and sensitivities of the transducers at the areas are calibrated. At first, by setting the sensor l22 in the outer dark area, values of the output signals of the transducers l32a and l32b, and then the values are input in the computing circuit 228. It is assumed that quantity of light (light intensity) received by the transducers is "$I_a$", and the output values of the transducers are "$VA_1$" and "$VB_2$", respectively. Next, the sensor l22 is shifted to transparent parts in the illuminating area where is no register mark, and also output signal values are measured to be input to the computing circuit 228. The light intensity (quantity of light) received at this case is set to "$I_b$" and voltages of output signals are set to "$V_1$" and "$V_2$". According to calibration basing on the twice operation, characteristics of the transducers l32a and l32b shown in Fig. l8 are identified. The calibrated sensor l22 is set on the positions of the register marks of one of the first color original films, as described the above. If the center of the register mark line l34 aligns with borders of the transducers l32a and l32b, light intensities impinging on the two respective transducers become the same value. If this value is assumed to be "$I_c$", then, difference between output levels, "$VC_1$" and "$VC_2$", of the transducers l32a and l32b becomes "$l$" in Fig. l8 basing on linear characteristics of the transducers. Accordingly, if difference between actual output values ($VC_1 - VC_2$) coincides with the value "$l$", the center of an image of the register mark line l34 is accurately aligned with the borders of the transducers. The value "$l$" shown in Fig. l8 is given geometrically with the following formula.

$$l = [(VA_1 - VA_2) - (VB_1 - VB_2)] \times (I_b - I_c)/(I_b - I_a) + -(VB_1 - VB_2)$$

wherein though characteristics of the photoelectric transducers differ from one another every element, these characteristics are surely linear, so that, for example, if description is given regarding the transducer l32a,

$$(I_b - I_c)/(I_b - I_a) = (VB_1 - VC_1)/(VB_1 - VA_1).$$

Accordingly,

$$l = [(8VA_1 - VA_2) - (VB_1 - VB_2)] \times (VB_1 - VC_1)/(VB_1 - VA_1) + (VB_1 - VB_2).$$

Therefore, it may be sufficient that if this value becomes equal to the difference value $(VC_1 - VC_2)$ between the output signals of the transducers l32a and l32b actually detecting the image l34. That is, the sensor l22 is transported in the X direction shown in Fig. l8 up to a position at which the value "m" of the following expression reduces to zero.

$$[(VA_1 - VA_2) - (VB_1 - VB_2)] \times (VB_1 - VC_2)/(VB_1 - VA_2) + (VB_1 - VB_2) - (VC_1 - VC_2) = m \quad ........(I)$$

In this case, since the values of $(VA_1)$, $(VB_1)$, $(VA_2)$ and $(VB_2)$ have already been stored in the computing circuit 228, the value "m" is determined by computing the afore-described according to the output signals $(VC_1)$ and $(VC_2)$ of the transducers l32a and l32b. In the case of the value "m" of the formula (I) reducing to zero, as the center of the line image l34 is aligned with the border lines of the transducers l32a and l32b, transportation of the working head 94 provided with sensors l22 is stopped. The afore-mentioned operation is simultaneously carried out with respect to the other transducers l33a and l33b to align the center of the line image l34 with their border lines. When desired sensors l22 are aligned with the respective register marks, by reading out X -Y positions of the working head 94, the gap between the data read out of the digitizer 2l0 and the actual positions of the register marks can be measured. A value of the gap is stored in the control device of the apparatus. In the above described operation, it is preferable to reduce "m" exactly to zero, however, it is difficult to control driving of the working head 94 so that the "m" may become zero, so that there is set up suitable allowed limit. It should be understood that in this specification the alignment of the sensors with the register marks means that there is included this allowed limit therein. In Fig. l7 there is shown another embodiment of the control circuit. In this embodiment an output of the transducer l32a is, same as that of shown in Fig. l6, fed to the computing circuit 228 through the A/D converter 224, on the other hand an output of the transducer l32b is sent to a differential amplifier 230 in which difference between the output of the former (transducer l32a) and that of the latter (transducer l32b) is produced, and then the difference is sent to the circuit 228. Thus, in this embodiment it is adapted that calculations $(VA_1 - VA_2)$, $(VB_1 - VB_2)$ and $(VC_1 - VC_2)$ in the formula (I) are carried out not by the computing circuit 228 but by the differential amplifier 230. Further, in computing circuits of the afore-described type use, in general, as shown in Fig. l9, a device composed of amplifiers 232 and 234 and a differential amplifier 236. Each of outputs of the transducers l32a and l32b is amplified with the amplifiers 232 and 234 respectively, and thereafter they are input to the differential amplifier 236 and the difference is output. In this case also by adjusting positions of the sensors so that an output of the differential amplifier 236 may be reduced to zero, it is possible to make them in desired alignment, however, if these transducers have not identical characteristics, accurate centering can not be achieved. For this reason, in the device each of the amplifiers 232 and 234 is provided with respective variable resisters 238 and 240 by which gain of each of the transducers is set to the same level, and that with variable resisters 242 and 244 offset voltage must be adjusted. That is, in this device troublesome adjustment as afore-described is necessary. While the devices of the above-described two embodiments there is no necessity of such troublesome adjustment.

The first color base sheet is removed from the positioning and composing table 6, after position gap data of register marks of all original films composed on the first color base sheet are detected and stored. Then, the first color base sheet is transported to the base sheet receiving device l8. This transportation is carried out by holding the trailing edge of the base sheet with the base sheet carrier 72. After the leading edge of the base sheet passed positions of the register pins l2, the pins l2 are projected on the surface of the table 6 by the pneumatic cylinder l3.

With respect to setting of the second base sheet, the following operation is performed. The uppermost sheet among base sheets which are being piled in the base sheet supplying device l4 and on which original films are not adhered yet is transported onto the positioning and composing table 6 with the same procedure as that of the first color base sheet, and with the register pins l2 it is positioned to fit onto the surface of the positioning and composing table 6 with the brush 82, and held by vacuum pressure.

Carrying and aligning operation of original films is performed as follows. Simultaneously with (or separately) the setting of the second base sheet, required film cassette 20 is transported from the waiting or stand-by position 22 to the supplying position 24 by the cassette driving means 26. The film carrier 96 which is driven together with the working head 94 by driving the sliding frame 64 and the saddle 86 is aligned with directly above the edges of the original films stored in the film cassette 20. Then, the uppermost sheet of the piled original films is held by vacuum sucking operation, and transported onto the position detecting stage 4. The uppermost sheet (original film) is released from the carrier 96 and is sucked to the groove 8 to be held on the stage 4. With the same driving operation the working head 94 is moved to that the sensors 122 may be aligned with designated portions of the stage 4. At this time register marks of the original film are to be aligned with the sensors 122, but it is impossible to eliminate somewhat error, which results in generation of a gap between the center of the register mark and a position of an optical axis of the sensor. Data regarding this gap are detected by the sensors 122 and stored, as well as the register marks of the first color original films. The working head 94 shifts toward the X and the Y directions according to the stored gap data, and rotates in the 0 direction to correct the gap. This gap correction results in correcting position error of the original films in the film cassette 20 and also correcting position error of the original film which generates during the original film being transported from the film cassette 20 onto the stage 4. However, the afore-mentioned gap correction is also possible to perform the afore-mentioned correcting operation by controlling shift and rotation of the working head 94 in the following step for positioning the original film held on the stage 4 to a base sheet set on the positioning and composing table 6. After the sensors 122 are aligned with register marks of the original films, the working head 94 descends to contact with the original film being held on the stage 4, and operates the vacuum pump to suck the original film by the groove 118, and simultaneously therewith air is blown from the groove 8 of the stage 4, thus, the original film is held after the working head 94 is accurately aligned. Thereafter, the working head 94 begins to elevate and leaves off from the stage 4.

The tape applicator 180 is provided with a wheel 195 on which a roll 196 of a both-faced type adhesive tape is previously loaded, and adheres the leading end part of the adhesive tape onto the circumference of the polygonal rotor 198. Then, the leading end part of the adhesive tape is fed to the upper face of the polygonal rotor 198 by operating the pneumatic cylinder 190 several turns. The fed adhesive tape is cut to tips of small size by the knife 210. The faces of the rotor 198 are made of materials such as fluoroplastic resin or the like which are easy to be peeled off the adhesive tape applied thereon, but at the vicinity of the knife 210, the roller 202 retains the tape from the rotor 198, and prevents the tape from deviating from the rotor 198 in the case of the tape being cut. The working head 94 which alignes and holds the original film is transported onto the tape applicator 180 from the stage 4, and when portions to which tips of the adhesive tape of the original film held by the working head 94 are applied reach to positions at which the portions are aligned with directly above the rotor 198, it stops. When the vertical board 188 is ascended by means of the pneumatic cylinder 190, the cutter arm 209 begins to advance along a slope of the cam 212, and the cutting knife 210 escapes from the slit 199 of the rotor 198. If the vertical board 188 is ascended higher, the ratchet 206 comes to engage with the hook 207 to rotate a shaft of the the rotor 198 a certain angle (in this embodiment 60), and one of the faces of the rotor 198 to which the tip of the adhesive tape is applied is set underside thereof. This position of the rotor is held by the cam 205. If the vertical board 188 is further ascended, at first the press pan 214 contacts with an original film held by the working head 94, and then the tip of the adhesive tape applied to the upside face of the rotor 198 is adhered to a position where the original film is aligned. Next, the vertical board 188 is descended by driving the pneumatic cylinder 190, the rotor 198 leaves the original film. Then, since adhesion of the tape is larger than adhesion between the original film side and the face of the rotor 198 (which is easy peelable), the tip end of the adhesive tape separates from the face of the rotor 198 and adheres to any desired portion of the film. At this time the press pan 214 is still pressing the original film to the underside face of the working head 94 to keep alignment of the film. Further the vertical board 188 descends, the cutter arm 209 begins to go back according to the rotation of the cam 212, and the knife 210 is inserted into the slit 199 of the rotor 198 to cut the tape. The afore-mentioned procedures for applying the tip of the adhesive tape onto the one portion of the original film are repeated each of desired portions. Thus, tape applying operation onto an original film is completed.

The working head 94 which holds the original films to which the tips of the adhesive tape are applied is raised, and transported on the positioning and composing table 6, and according to positioning data stored by detecting register marks of the first color original films, the original film held by the working head 94 is aligned with the same position of the first color base sheet where corresponding first color original film is composed. After the alignment having finished, the working head 94 begins to descend, and makes the original film contact with the second base sheet set on the table 6, by releasing vacuum pressure and supplying air from the hollow pipe to press the original film to the base sheet. Thus, the original film is adhered to the base sheet with the tips of the tape. The procedures are repeated until all the second color original films have been composed on a base sheet. When the composing operation of the second color original films is completed, the base sheet is transported to the base sheet receiving device 18 by the base sheet carrier 72. The same operation is repeated regarding the third color original films and all the followings thereto. In this composing operation, according to condition of layout, there may be some cases in which a plurality of original films are positioned to same portions of the base sheet partially overlapped manner. If the film holding face of the composing head 94 is hard, areas at which the original films are being overlapped are pressed, and other areas at which no overlapping is occurred, that is, areas on which one sheet film is positioned are not sufficiently pressed which results in unstable composition. However, since at the lower face of the working head 94 there is installed the board 107 made of a flexible material and the original film is pressed to the base sheet by pneumatic pressure, the afore-mentioned defect can be eliminated. That is, as shown in Fig. 20, in the case of pressing the original film (F) to the base sheet (S), between the flexible board 107 and the working head 94 of the grooves 118 where is choked by the original film (F), compressed air is fed from the hollow pipe and the flexible board 107 extends toward the lower part. Accordingly, the original films are pressed with approximately same pressure even at areas where a plurality of original films are being overlapped and other areas where one sheet film is being placed. Thus, sure adhesion can be expected.

In the above descriptions processes for composing a plurality sets of original films included in one layout to each of base sheets for every elemental color are clarified, the afore-described processes can also applied continuously to composing operation in which larger number of original films than the case where layout is only one are used in plural layouts (that is, a plurality kinds of prints). In this case, picking up data basing on the digitizer 212 in preparing step in each layout and storing thereof, when each of base sheets for respective layouts is stored in the base sheet supplying device 14, each of base sheets on which the first color original films of the respective layouts are composed is piled on the top of each of groups of the base sheets orderly. According to the above descriptions, in the preparation step the first color original films composed on the first base sheet by hand work are not removed from the base sheet, but are to be applied in the following process, however, it may be re-composed by using the apparatus according to the present invention, as same as original films which follow to those of the second color.

(Another embodiment)

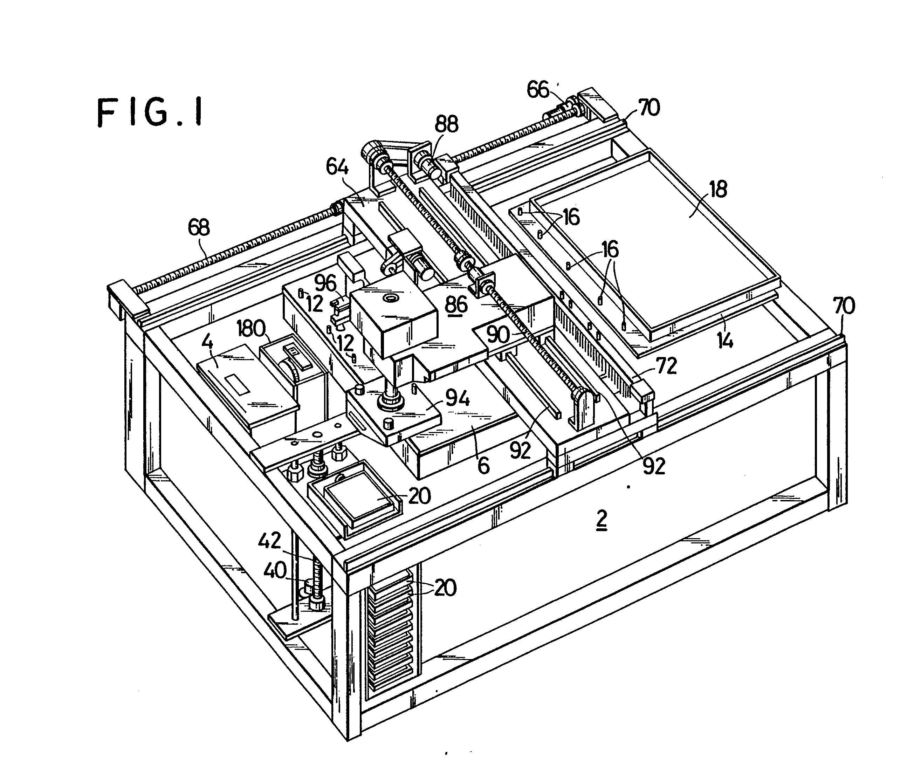

In Fig. 27 which shows the second embodiment of the present invention the same reference number is given to each of identical parts or components of the embodiment shown in Fig. 1. Different respect of the second embodiment from those of the first embodiment lies in that loading the base sheet on the positioning and composing table 6 and removing it therefrom are carried out by hand work. Accordingly, in this apparatus the base sheet supplying device 14, the base sheet receiving device 18 and the base sheet carrier 72 shown in Fig. 1 are omitted, and thus the apparatus can be made compact so that floor space can be reduced, which results in possibility of effective cost down. In the case of this embodiment, operation and procedures other than loading and removing the base sheet are same as those of the first embodiment. The loading and removing operation of the base sheet can be performed by opening the upper surface of the table 6 by moving the sliding frame 64 to the right end portion of traveling stroke on the main frame 2.

While but some embodiments of the present invention have been shown and described, it will be evident that numerous changes and modifications may be made therein. It is, therefore, to be understood that it is not intended to limit the invention to the embodiments shown, but only by the scope of the claims which follow.

## Claims

1. An apparatus for composing a plurality of original films which have register marks on desired positions of a base sheet by positioning and adhering thereon respectively, characterized by comprising:
    a main frame;
    a positioning and composing table provided on said main frame on which a base sheet is installed ;
    film cassettes for storing original films;
    a position detecting stage on which an original film is set prior to be composed at measuring positions of register marks provided therewith;
    an original film carrier for transporting one of said original films from said film cassette onto said stage;
    a working head for transporting said original film from said stage to said positioning and composing table to adhere said original film to said base sheet by pressing it at a desired position thereof;
    photoelectrical sensors provided to said working head for detecting register marks of said original film and measuring positions of said original film;

a sliding frame which moves on said main frame in one direction; and

a saddle provided to said sliding frame so as to be slidable in crossing direction with said sliding frame and supporting said original film carrier and said working head.

2. An apparatus according to claim I, further comprising:

a base sheet supplying device installed in said main frame for piling and storing a plurality of base sheets;

a base sheet receiving device installed in said main frame for receiving a base sheet after original films having been composed thereon; and

a base sheet carrier which is provided to said sliding frame and transports a base sheet to said positioning and composing table from said base sheet supplying table, and further transports said base sheet to said base sheet receiving device from said positioning and composing table.

3. An apparatus according to claim I, wherein a tape applicator is provided between said position detecting stage and said positioning and composing table for applying tips of an adhesive tape to said original film held on said working head.

4. An apparatus according to claim I, wherein a plurality of film cassette are overlappedly installed at a waiting position, and a cassette driving means which shifts one of said plurality of film cassettes being set at an engaging height by vertical movement to a supplying position in engagement therewith is provided;

each of said film cassettes being provided with at least one supporting board on which original films are piled and spring means for actuating said supporting board upwardly.

5. An apparatus according to claim I, wherein said original film carrier is further comprised with a plurality of suckers which descend to a height at which the top surface of said original films in said film cassette of said supplying position and move between a first position and a second position to perform sucking operation at the second position by vacuum pressure.

6. An apparatus according to claim I, wherein said photoelectric sensor is comprised at least one pair of electric transducers of same size and same characteristics which are set side by side, an image of a register mark line is projected onto border lines of said photoelectric transducers to ascertain alignment said image with the border lines by outputs of said transducers.

7. An apparatus according to claim I, wherein said working head comprises:

a main block having an opening for sucking and/or injecting an air at the underside surface;

a thin flexible board being provided at the underside surface of said main block and having suction grooves for engaging with said opening;

a vacuum suction means and a compressed air supplying means either of said means is connected to said opening through pipe line switching valves.

8. An apparatus according to claim I, wherein said tape applicator further comprising:

a polygonal rotor means supported on the uppermost part of said supporting board and moving vertically between a height at which it contacts with the bottom surface of the aligned working head and a position at which it separates from the surface;

a tape supplying means for supplying a both-faced type adhesive tape onto the circumference of said rotor means and pressing it thereto; and

a tape cutting means for cutting said supplied tape at each corner of said rotor means.

9. An apparatus according to claim 8, wherein the circumference of said rotor means is made of a material such as fluoroplastic resin from which said adhesive tape is peelable.

I0. An apparatus according to claim 8, wherein a ratchet driving means for rotating said rotor means a certain angle in linking with vertical movement of said rotor means, and a positioning cam means for ratching one surface of said rotor means to an upward position are further provided.

II. An apparatus according to claim 8, wherein said tape cutting means is a knife means which is driven in the axial direction of said rotor means in liking with the vertical movement of said rotor means.

I2. An apparatus according to claim 8, wherein a press pan which presses an original film to the bottom surface of said working head is provided underside of said working head so that it may touch with the surface of said original film prior to the rotor means touching therewith and leave from the surface of said original film after the rotor means having left therefrom.

I3. A method for detecting positions of register marks in an apparatus for composing a plurality of original films wherein a detecting part providing at least a pair of photoelectric converting elements and register marks are relatively moved and according to outputs of at least said pair of photoelectric converting elements, characterized in that:

each output of said respective photoelectric converting elements is measured at two points where brightness is different from each other;

difference between said outputs of said pair of photoelectric converting elements is calculated basing on data of brightness when said photoelectric converting elements is detecting said register marks and data obtained by said measurement; and

said positions of said register marks and said positions of said detecting parts are judged to be in coincidence with, when said calculated value and said actual output difference between said photoelectric converting elements in the case of the register marks being detected are equal.

14. A method according to claim 13, wherein said data of brightness is an output of one of said photoelectric converting elements when said register marks are being detected.

# FIG.1

0 234 591

# FIG.2

# FIG.3

# FIG.4

# FIG.5

# FIG.6

# FIG.7

# FIG.8

# FIG.9

100

138    104    86
150
136
156    142
139    140    148
122    122
164    162    166
160    158    124    94
108

# FIG.10

86    104
136    140
138
142
122    158    124
164
108    94

FIG. 11

94

104

86

136

146

150

148

144

140

142

166

152

162

156

160

124

138

154

139

164

158

# FIG.12

0 234 591

# FIG.13

# FIG.14

# FIG.15

0 234 591

# FIG.16

220 224 228

132a

222 226

COMPUTING CIRCUIT

# FIG.17

220 224 228

132a

132b 222 230 226

COMPUTING CIRCUIT

# FIG.19
( CONVENTIONAL DEVICE )

238 232

132a 242

240 236

132b 234

244

# FIG.18

OUTPUT VOLTAGE OF AMPLIFIER (V)

VB1
VB2
(VC1)
VA1
L1
L2
ℓ
(VC2)
VA2

Ia    Ic    Ib    (I)

QUANTITY OF LIGHT

# FIG.20

94
108
F    F
T    T
S

# FIG.21

# FIG.22A

# FIG.22B

# FIG.22C

# FIG.22D

# FIG.23A

# FIG.23B

# FIG.24A

# FIG.24B

# FIG.25A

# FIG.25B

# FIG.25C

# FIG.25D

# FIG.25E

# FIG.26

258

254

252

256

250

0 234 591

# FIG.27

0 234 591